# FASCICULE DE BREVET EUROPEEN

(11) **EP 0 710 066 B1**
(45) Date de publication et mention de la délivrance du brevet: **07.10.1998**
(21) Numéro de dépôt: 95402369.3
(22) Date de dépôt: 24.10.1995
(51) Int. Cl.: H05K 7/14

(54) **Tiroir pour cartes électroniques et son support**
Einschub für elektronische Karten und sein Träger
Drawer for electronic cards and its support

(30) Priorité: 27.10.1994 FR 9412881
(43) Date de publication de la demande: 01.05.1996
(73) Titulaire: GEC ALSTHOM TRANSPORT SA, 75016 Paris (FR)
(72) Inventeur: Ruque, Christian, F-69960 Corbas (FR)
(74) Mandataire: Gosse, Michel

(56) Documents cités:
- EP-A- 0 213 205
- DE-U- 8 910 752
- US-A- 5 040 992
- US-A- 5 259 784

## Description

La présente invention concerne les ensembles de support de cartes électroniques, en général, et porte, plus particulièrement, sur un tiroir pour cartes électroniques à embrochement et débrochage automatiques et son support.

Dans le tiroir pour cartes électroniques connu sous le nom de tiroir "Eurofer" les cartes électroniques sont disposées perpendiculairement à la face avant du tiroir.

Ces cartes électroniques comportent, à leur extrémité arrière, des connecteurs de fond de carte.

Ces cartes électroniques sont montées dans le tiroir par coulissement dans des glissières avec jeu de façon à s'enficher dans les connecteurs de carte disposés en vis-à-vis dans le tiroir.

Un jeu permettant le montage des cartes électroniques sur ces connecteurs est réalisé par des glissières de façon rigide sur la carte.

En vis-à-vis avec ces connecteurs de fond de carte, des connecteurs de sortie sont fixés à la structure du tiroir.

Ces connecteurs de sortie sont des connecteurs de type mâle munis de pions de centrage et sont montés flottant sur la structure du tiroir. Le montage flottant des connecteurs de sortie est obtenu par des entretoises avec jeu.

L'ensemble de ces connecteurs de sortie est réparti sur la face arrière du tiroir.

Le tiroir "Eurofer" est susceptible d'être manipulé par deux poignées disposées sur sa face avant et possède également deux glissières de guidage sur ses côtés.

Afin de rendre le tiroir débrochable, il est nécessaire d'adapter dans la structure de son coffre une structure intermédiaire permettant:
- de supporter des connecteurs femelles de façon flottante, ces connecteurs femelles étant disposés en vis-à-vis des connecteurs mâles de sortie, et
- d'installer sur les côtés des moyens permettant une reprise du tiroir par les glissières de guidage.

De plus, des liaisons de câblage du coffre partent à partir des connecteurs femelles de sortie disposées sur la structure coffre.

Pour mettre en place le tiroir, il est nécessaire:
- de présenter le tiroir en face des glissières de guidage disposées sur le coffre, et
- de faire coulisser le tiroir sur les glissières de guidage, de façon à arriver en butée à l'avant du tiroir.

L'embrochement des connecteurs mâles et femelles de sortie, disposés sur le tiroir et dans le coffre, est faite grâce au centrage de chaque connecteur et des jeux fonctionnels. Le centrage des connecteur est réalisé automatiquement grâce aux pions de centrage et aux entretoises.

La fixation du tiroir sur sa structure se fait au moyen de quatre ou huit vis disposées à l'avant du tiroir.

D'autres inconvénients de ce tiroir "Eurofer" sont cités ci-après:
- un coût élevé du fait qu'il nécessite des connecteurs de sortie chers et du fait du nombre élevé de connecteurs, du câblage filaire important et de l'augmentation du nombre de points de connectique,
- une profondeur importante du tiroir embroché avec le câblage du coffre du fait du volume important des connecteurs, de la profondeur importante du tiroir car il faut passer par deux étages de connecteurs flottants, une zone de câblage intermédiaire et une zone d'implantation des cartes, de l'emplacement des connecteurs de sortie et de l'emplacement du câblage de sortie.
- une mise en place du tiroir délicate du fait de sa masse et de sa profondeur, de la position de son centre de gravité et de sa disposition car pour faire coulisser le tiroir il est nécessaire d'être à l'avant de celui-ci, les glissières étant alors cachées,
- la réparation ou les modifications du câblage de sortie sont quasiment impossibles par la face avant du tiroir du fait de la position des connecteurs de sortie et de la position du câblage du coffre à l'arrière des connecteurs et loin de la face avant du tiroir, d'où la nécessité de disposer d'autres zones d'accès ou de démonter la structure du coffre,
- le débrochement du tiroir se fait manuellement en tirant avec une force suffisante sur les deux poignées disposées à l'avant du tiroir, cette force a tendance à augmenter du fait de l'augmentation du nombre de connecteurs de sortie,
- le non respect des normes de vibrations, de chocs et des perturbations électromagnétiques, ces normes ayant tendance à être de plus en plus sévères.

Aussi un but de l'invention est-il un tiroir pour cartes électroniques à embrochement et débrochage automatiques ne présentant pas les inconvénients des ensembles support de l'art antérieur.

Le document US-A-5 259 784 montre un tiroir dans lequel les cartes électroniques sont connectées sur des cartes mères qui sont disposées sur au moins deux plans et parallèlement à la face avant dudit tiroir.

C'est le mérite de la demanderesse que de concevoir un tiroir pour cartes électroniques à embrochement et débrochage automatiques permettant de diminuer les temps d'installation et de supprimer les problèmes de connexion, de fiabilité, de câblage et d'accession aux liaisons externes.

L'invention porte sur un tiroir avec cartes électroniques, ledit tiroir étant susceptible de s'introduire dans un support de tiroir, lesdites cartes électroniques étant connectées sur des cartes mères, lesdites cartes mères étant disposées sur au moins deux plans, ledit tiroir étant à embrochement et débrochage automatiques et lesdites cartes mères étant disposées parallèlement à la face avant dudit tiroir.

Le tiroir et son support de tiroir satisfaisont également à l'une quelconque des caractéristiques suivantes:
- ledit support de tiroir est de forme générale intérieure semblable à l'enveloppe générale extérieure dudit tiroir,
- des connecteurs de sortie sont fixés audit support de tiroir, des connecteurs dudit tiroir étant susceptibles d'être connectés automatiquement auxdits connecteurs de sortie.

Le tiroir de l'invention satisfaisait à l'une quelconque des caractéristiques suivantes:
- chaque plan comporte une ou plusieurs cartes mères, lesdites cartes mères et leurs cartes électroniques étant superposées les unes aux autres, de manière à former une superposition de compartiment dont l'enveloppe générale extérieure est de forme générale pyramidale,
- la face avant du tiroir est disposée face à la carte mère, ou à l'ensemble des cartes mères d'un même plan, de surface la plus grande,
- des connecteurs de sortie sont fixés aux extrémités desdites cartes mères,
- les compartiments du tiroir comportent des plaques de rigidification des cartes mères et/ou de plaques de protection des cartes électroniques,
- au moins une carte mère d'un compartiment n a été supprimée de manière à augmenter le nombre de connecteurs sur la carte mère du compartiment suivant n+1,
- au moins une carte mère d'un compartiment n a été décalée, de manière à être alignée sur un des côtés du compartiment précédent n-1 ou du compartiment suivant n+1, afin que les connecteurs de ladite carte mère dudit compartiment n soient plus particulièrement disposés sur l'un des côté du tiroir,
- l'ensemble des compartiments A-C sont aligné sur un des côtés du tiroir, afin de disposer l'ensemble des connecteurs sur un seul côté du tiroir,
- au moins un compartiment comporte une carte mère unique,
- au moins un compartiment comporte deux demi-cartes mères,
- au moins un compartiment comporte quatre quarts de cartes mères,
- au moins un compartiment comporte une demi-carte mère et deux quarts de cartes mères,
- les surfaces globales de la carte mère et des ensembles de cartes mères de chaque plan ont des valeurs croissantes fonctions de leur position dans ledit empilage de forme pyramidale, la carte mère, ou l'ensemble de cartes mères, la plus proche de la face avant du tiroir ayant la surface la plus grande,
- les cartes mères sont disposées sur des plans parallèles à la face avant du tiroir au moyens d'entretoises solidaires desdites plaques de rigidification des cartes mères et/ou desdites plaques de protection des cartes électroniques.

Le tiroir pour cartes électroniques à embrochement et débrochage automatiques a comme avantages:
- de supprimer en grande partie le câblage filaire du fond de panier, tout en conservant le débrochage automatique,
- que le volume et notamment la profondeur du tiroir et de son support sont fortement diminués du fait de l'emploi et du positionnement des cartes mères à la place de cartes normalisées de l'art antérieur, de la suppression du câblage de fond de panier avec ses deux rangées de connecteurs, du déplacement de la zone de câblage de sortie de l'arrière du tiroir, sur les zones latérales; ce qui précède facilite l'implantation dans les coffres,
- d'adapter parfaitement le volume et la profondeur du tiroir suivant la fonction à réaliser; en effet, il suffit de construire, par juxtaposition de niveau le tiroir s'adaptant le mieux à la fonction à réaliser, faire un tiroir à un, deux ou trois compartiments, ce qui est impossible avec les dispositifs de l'art antérieur,
- de s'adapter facilement au besoin fonctionnel en terme de câblage de sortie par la choix du nombre de connecteurs de sortie par compartiment, par les différents choix de format de carte et ce pour chaque comportament et par un positionnementdes cartes mères différemment pour chaque comportament,
- de permettre une bonne tenue aux vibrations et aux chocs des cartes électroniques du fait que celles-ci sont reprisent mécaniquement sur des tôles au moyens de vis en plusieurs points.

D'autres buts, caractéristiques et avantages de l'invention apparaîtront à la lecture de la description du mode de réalisation préféré du tiroir pour cartes électroniques à embrochement et débrochage automatiques, description faite en liaison avec les dessins joints dans lesquels:
- la figure 1 est une vue de dessus en coupe partielle du tiroir pour cartes électroniques à embrochement et débrochage automatiques comportant trois étages et de son coffre, tous deux conformes à l'invention, selon un mode de réalisation préféré,
- la figure 2 est une vue de dessus en coupe partielle du tiroir et de son coffre selon le mode de réalisation préféré, le tiroir étant introduit dans son coffre,
- la figure 3 représente une vue en coupe du détail III-III repéré à la figure 2, les connecteurs de sortie du tiroir étant connectés,
- la figure 4 représente la vue en coupe du détail III-III repéré à la figure 2, les connecteurs de sortie du tiroir étant déconnectés,
- la figure 5 est une vue de dessus en coupe partielle du tiroir pour cartes électroniques selon le mode de réalisation préféré illustrant un agencement particulier permettant de disposer de quatre rangées de connecteurs sur la carte mère du deuxième compartiment,
- la figure 6 est une vue de dessus en coupe partielle du tiroir pour cartes électroniques selon le mode de réalisation préféré illustrant un agencement particulier permettant de disposer les connecteurs plus particulièrement sur l'un des côtés du tiroir,
- les figures 7 et 8 sont des vues de dessus en coupe partielle du tiroir pour cartes électroniques selon le premier mode de réalisation préféré illustrant deux autres agencements particuliers, et
- les figures 9A à 9F sont des représentations schématiques de combinaisons possibles entre différentes cartes mères pour chaque compartiment.

De manière générale, dans un tiroir 1 pour cartes électroniques 2 susceptible de s'introduire dans un support 11 de tiroir 1, les cartes électroniques 2 sont connectées sur des cartes mères 3A-3C disposées sur au moins deux plans.

Dans le tiroir et son support de l'invention, le tiroir est à embrochement et débrochage automatiques et les cartes mères 3A-3C sont disposées parallèlement à la face avant 6 du tiroir 1.

Le support de tiroir est de forme générale intérieure semblable à l'enveloppe générale extérieure dudit tiroir 1.

Des connecteurs de sortie 4A-4C sont, de préférence, fixés au support 11 de tiroir 1, des connecteurs 5A-5C du tiroir 1 étant susceptibles d'être connectés automatiquement auxdits connecteurs de sortie 4A-4C.

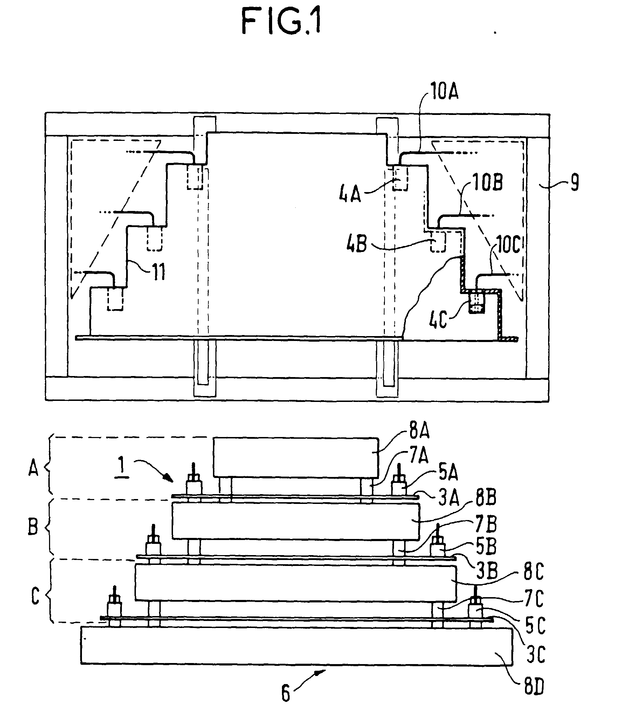

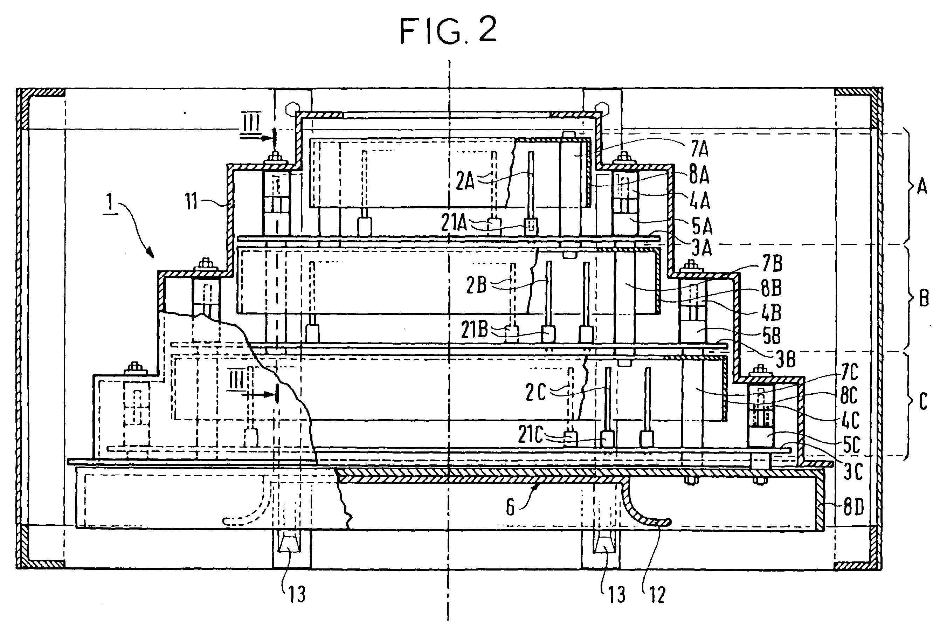

Les figures 1 et 2 représentent deux vues de dessus en coupe partielle d'un mode de réalisation préféré du tiroir pour cartes électroniques à embrochement et débrochage automatiques comportant trois étages ainsi que de son coffre tous deux conformes à l'invention.

Conformément à ce mode de réalisation préféré de l'invention, le tiroir 1 pour cartes électroniques 2A-2C comporte des cartes électroniques 2A-2C, appelées cartes électroniques filles, connectées sur des cartes mères 3A-3C.

Ces cartes électroniques 2A-2C sont connectées sur les cartes mères au moyen de connecteurs de cartes 21A-21C.

Les cartes mères 3A-3C sont disposées, sur au moins deux plans, parallèlement à la face avant 6 du tiroir 1, chaque plan comportant une ou plusieurs cartes mères.

Les plans sont superposés les uns aux autres, de manière à former un empilage de forme pyramidale.

La face avant 6 du tiroir 1 est disposée face à la carte mère, ou à l'ensemble des cartes mères d'un même plan, de surface la plus grande.

Le tiroir 1 pour cartes électroniques 2A-2C comporte donc de grandes cartes mères 3A-3C sur les petits côtés desquels sont fixés des connecteurs mâles de sortie 5A-5C.

Ces connecteurs mâles de sortie 5A-5C sont susceptibles d'être connectés automatiquement aux connecteurs femelles 4A-4C. Ces connecteurs femelles de sortie 4A-4C sont solidaires de cablâge de sortie 10A-10C.

Chaque modèle de cartes mères possède un ou plusieurs connecteurs mâles de sortie 5A-5C.

L'ensemble des cartes mères est disposé parallèlement au plan de la face avant 6 du tiroir 1 de manière à former un empilage de plusieurs compartiments A-C de cartes mères.

Ces cartes mères ont des largeurs différentes fonction du compartiment dont elles dépendent.

L'ensemble des cartes mères est disposé et maintenu de manière à former un empilage de forme pyramidale.

Par empilage de forme pyramidale il faut comprendre un empilage de cartes mères tel que l'enveloppe fictive extérieure définie par l'ensemble des cartes mères se compose d'une succession de marches selon l'axe longitudinal et/ou selon l'axe radial pour former un podium selon l'un et/ou l'autre de ces axes.

Comme indiqué précédemment, la face avant 6 du tiroir 1 est disposée face à la carte mère, ou à l'ensemble des cartes mères d'un même plan, de surface la plus grande.

La réalisation du tiroir pour cartes électroniques de l'invention nécessite de fixer les différentes cartes mères entre elles par l'intermédiaire d'entretoises 7A-7C.

Ces entretoises 7A-7C sont de préférence solidaires de plaques de rigidification 8B-8D des cartes mères 3A-3C et/ou de plaques de protection 8A-8C des cartes électroniques filles 2A-2C.

Le tiroir pour cartes électroniques comporte également des moyens de préhension 12 solidaires de la face avant 6 du tiroir 1.

Ces moyens de préhension 12 sont, par exemple, des poignées ou encore des fenêtres respectivement fixées ou pratiquées sur la face avant 6 du tiroir 1.

Le tiroir pour cartes électroniques comporte un support 11 de tiroir 1 permettant une mise en place aisée dans un coffre 9. La mise en place du tiroir 1 dans le coffre 9 est d'autant plus facile que le tiroir est peu profond et qu'il possède donc un centre de gravité proche de la face avant.

Le tiroir pour carte électroniques à embrochement et débrochage automatiques est susceptible d'être introduit dans le support 11 au moyen de glissières 13 solidaires de la face inférieure du support 11 et s'étendant de l'avant du support jusqu'à l'arrière du support.

Le support 11 de tiroir 1 assure les fonctions suivantes:
- il réalise la fonction reposoir lors de l'approche du tiroir et cela sans grande précision, au moyen d'une proéminence à l'avant en partie basse du support,
- il réalise un centrage et un embrochage parfait sans visibilité, au moyen de faces inclinées réalisées sur les côtés du tiroir dans sa partie inférieure de manière à permettre de pré-centrer le tiroir automatiquement tout au long de son avancée dans son coffre,
- il empêche le tiroir de se présenter de biais par rapport aux connecteurs au moyen de quatre pions de centrage,
- il permet d'assurer un bon glissement du tiroir dans son support au moyen de deux glissières en plastique mais également un pré réglage à moins de 2mm pour réaliser l'embrochement final,
- il laisse passer les câbles de sortie 10A-10C par des perforations,
- il maintien les connecteurs femelles 4A-4C de façon flottante,
- il assure une bonne liaison mécanique de façon simple, au moyen de quatre vis, entre le tiroir et le support de coffre, ce qui a pour avantage de répondre aux normes les plus sévères en termes de vibration et de chocs.

Le support 11 de tiroir 1 a une structure en forme de podium dont la forme générale intérieure s'apparente à l'enveloppe générale extérieure des cartes mères 3A-3C empilées conformément à l'invention.

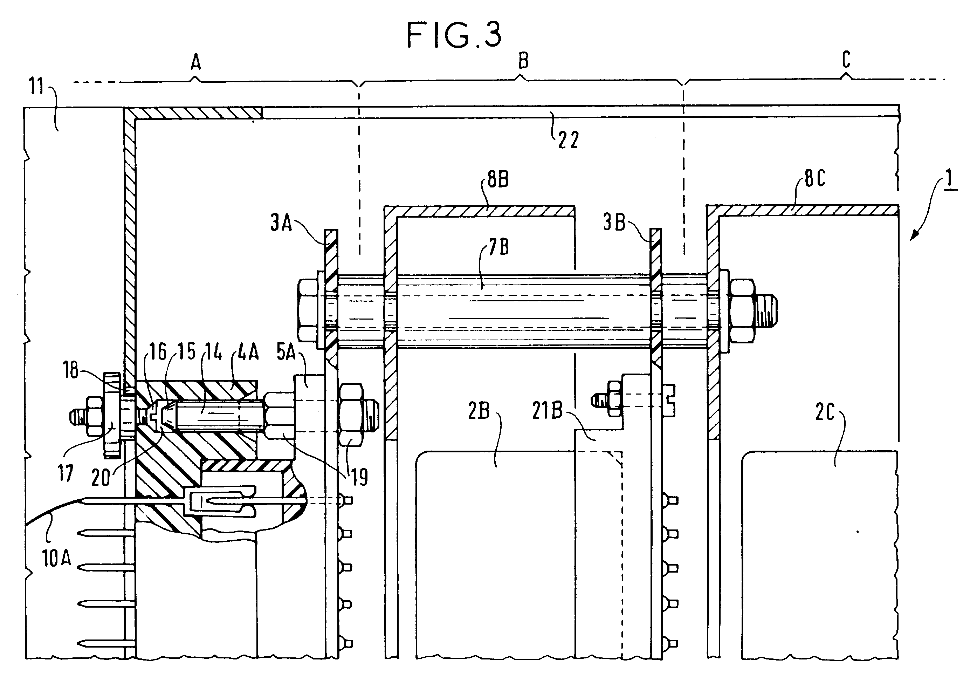

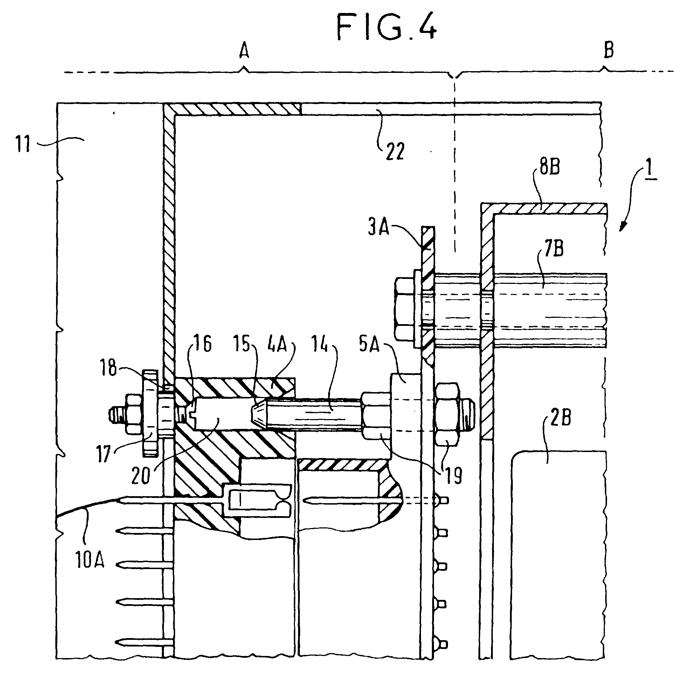

Les figures 3 et 4 représentent deux vues en coupe du détail III-III repéré à la figure 2, les connecteurs de sortie 4A, 5A du tiroir étant, respectivement, connectés et déconnectés.

On retrouve dans ces figures 3 et 4 le tiroir 1 et les cartes électroniques 2B, 2C associés, respectivement, aux deuxième B et troisième C compartiments, la carte électronique 2B étant connectée sur la carte mère 3B au moyen de connecteurs de cartes 21B.

Figurent également sur ces figures 3 et 4 les plaques de rigidification 8B, 8C associées, respectivement, aux deuxième B et troisième C compartiments ainsi que l'entretoise 7B associée au deuxième compartiment B.

Enfin, sont également représentés les connecteurs femelles 4A et mâles 5A associés au premier compartiment A.

La fixation des connecteurs de sortie 4A-4C au support 11 de tiroir 1 est faite par l'intermédiaire de moyens de fixation constitués de vis 16 et d'entretoises 17 de manière à permettre un flottement.

Ce flottement est obtenu au moyen d'un jeu 18, par exemple, de quelques dixièmes de millimètre de profondeur et de l'ordre de 2 mm autour des axes de fixation.

Le tiroir pour cartes électroniques comporte également deux pions 14 de centrage associés à chaque moyens de fixation des connecteurs de sortie 4A-4C.

Ces pions sont de préférence munis d'un chanfrein 15.

Les pions 14 sont fixés aux cartes mères 3A-3C auxquelles elles sont associées par des moyens appropriés connus 19 de manière à rendre les connecteurs mâles de sortie 5A-5C solidaires de la carte mère 3A-3C à laquelle ils sont associés.

L'accouplement des connecteurs mâles de sortie 5A est réalisé par la pénétration des deux pions dans des lamages 20 des connecteurs femelles de sortie 4A.

Les connecteurs mâles de sortie 4A-4C sont disposés de chaque côté du support 11 de tiroir 1 et sont décalés sur chaque compartiment de manière à ne pas être dans un même plan.

D'autres avantages du support de tiroir selon l'invention, sont données ci-après:
- il permet d'accéder au câblage de sortie 10A-10C par l'avant du coffre 9 sans être démonté, les connecteurs mâles de sortie 4A-4C étant orientés vers l'avant du tiroir,
- l'intégration du câblage coffre 10A-10C ne déborde pas de part et d'autre de la surface correspondante à la face avant 6 du tiroir 1 ce qui minimise l'encombrement du câblage en profondeur et permet de disposer le câblage à proximité de la face avant du tiroir et facilite toute intervention en cas de modification du câblage.

Pour cela, il est nécessaire de désolidariser les connecteurs femelles 4A-4C et de les avancer suffisamment pour accéder au câblage 10A-10C.

Le fait d'avoir un support de tiroir en forme de podium, conformément à une caractéristique de l'invention, a comme avantages de permettre la réalisation d'un écran efficace contre les perturbations électromagnétiques sur le pourtour du tiroir du fait de la présence de parois pleines et en partie supérieure, inférieure et latérale du fait de la présence de fenêtres 22.

Ces fenêtres 22 permettent également l'évacuation des calories internes.

Les fenêtres peuvent être obtenues soit par des trous réalisés directement dans les parois supérieures et inférieures du support de tiroir, soit en rapportant des tôles perforées.

Les fenêtres permettent d'utiliser les faces en escaliers du support 11 de tiroir 1 en forme de podium pour disposer les bornes de distributions (non représentées) du câblage 10A-10C, les moyens de maintien du câblage coffre et les barrettes de reprise (non représentées) des câbles blindés.

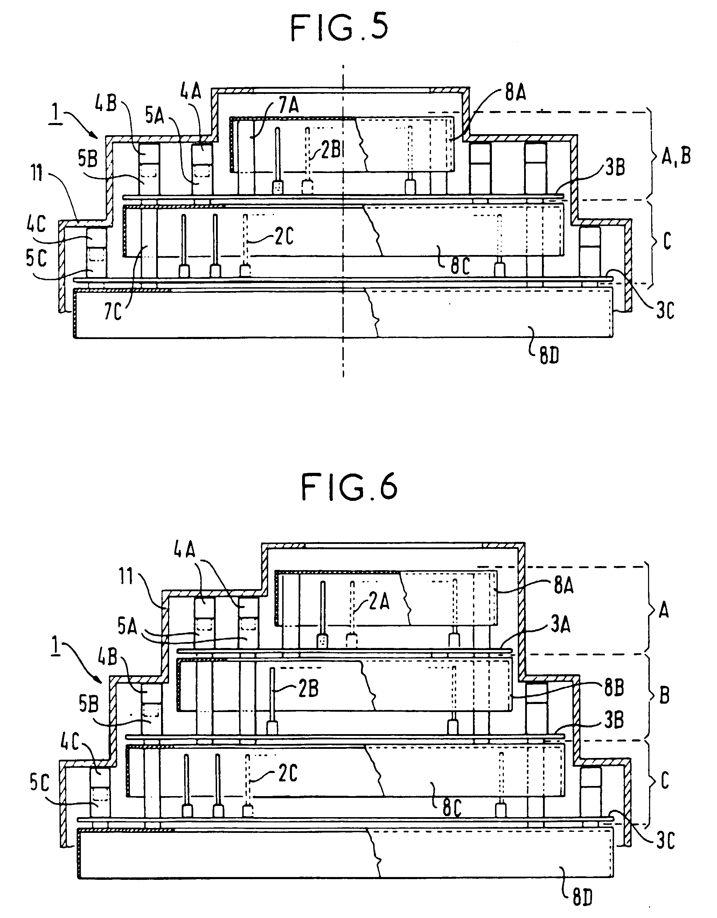

La figure 5 est une vue de dessus en coupe partielle du tiroir 1 pour carte électroniques 2A-2C illustrant un agencement particulier entre la carte mère 3B du deuxième compartiment et le premier compartiment A.

La suppression de la carte mère du premier compartiment A et de la plaque de rigidification et de protection du deuxième compartiment B, permet de disposer de quatre rangées de connecteurs 4A, 5A et 4B, 5B sur la carte mère 3B du deuxième compartiment B et, comme obtenues dans le mode de réalisation précédent, de deux rangées de connecteurs 4C, 5C sur la carte mère 3C du troisième compartiment C.

Dans ce mode de réalisation particulier, les entretoises de fixation 7B du deuxième compartiment B ont été supprimées, seules les entretoises 7A et 7C des premier et troisième compartiments subsistent.

De plus, subistent également les plaques 8C et 8D de rigidification des cartes mères 3B, 3C ainsi que les plaques de protection 8A, 8C des cartes électroniques 2B et 2C.

La figure 6 est une vue de dessus en coupe partielle du tiroir 1 pour carte électroniques illustrant un agencement entre le premier compartiment A et le deuxième compartiment B permettant de disposer tous les connecteurs 4A, 5A de la carte mère 3A du premier compartiment A sur l'un des côtés du tiroir 1 ou, plus précisément, sur l'un des côtés de la carte mère 3A du premier compartiment A.

Conformément à cet autre mode de réalisation représenté à la figure 6, il est possible de décaler l'un des compartiments n, par exemple le premier compartiment A, de manière à l'aligner sur un des côtés du compartiment précédent n-1 ou du compartiment suivant n+1, dans le cas représenté à la figure 4: le deuxième compartiment B.

Un tel agencement permet de disposer les connecteurs plus particulièrement sur une extrémité de l'une des cartes mères.

Il est également possible d'aligner plusieurs compartiments, par exemple les compartiments A et B, par rapport à un des autres compartiments, par exemple le compartiment C, de manière à répartir les compartiments selon un autre agencement.

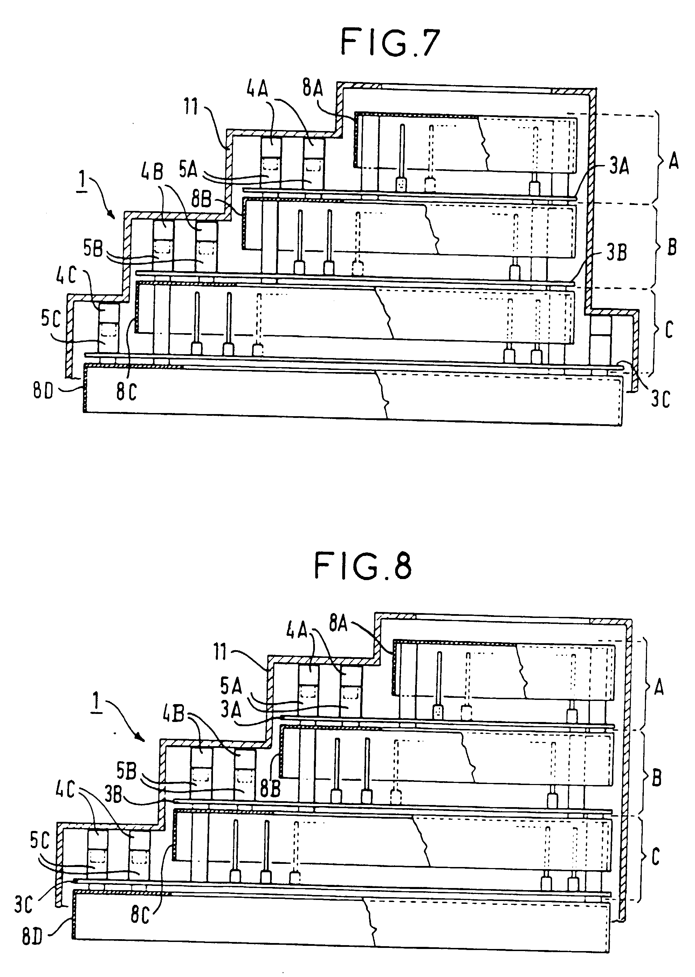

Un tel mode de réalisation est représenté à la figure 7.

Il est également possible d'aligner l'ensemble des compartiments A-C sur un des côtés du tiroir, un tel alignement est par exemple représenté à la figure 8.

Un tel agencement permet de disposer l'ensemble des connecteurs sur un seul côté du tiroir.

En liaison avec les figures 5 à 8 décrites précédemment, le support 11 de tiroir 1 est toujours de forme générale pyramidale.

Toutefois, certaines marches constituant le podium peuvent être supprimées en fonction des compartiments existants et de leurs alignements respectifs.

Il est possible de choisir et d'associer, pour chaque compartiment, les cartes mères souhaitées selon un grand nombre de combinaisons.

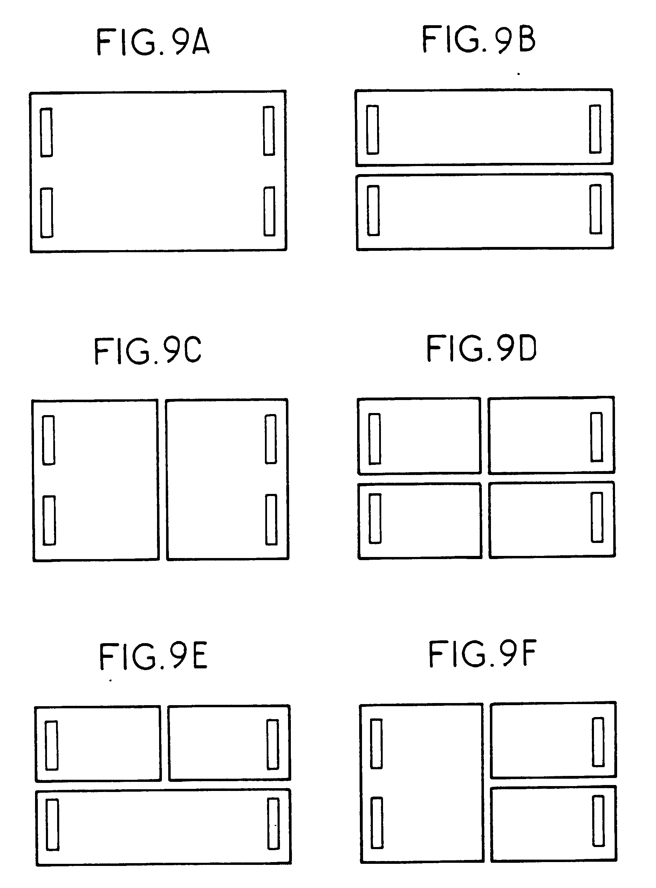

Pour un tiroir comportant six compartiments successifs, l'agencement des cartes mères selon une forme générale pyramidale est obtenu en sélectionnant les différentes cartes mères dans la liste ci-dessous:
- une carte mère unique (figure 9A),
- deux demi-cartes mères disposées horizontalement (figure 9B),
- deux demi-cartes mères disposées verticalement (figure 9C),
- quatre quarts de cartes mères (figure 9D),
- une demi-carte mère disposée horizontalement associée à deux quarts de cartes mères également disposées horizontalement (figure 9E), et
- une demi-carte mère disposée verticalement associée à deux quarts de cartes mères disposées verticalement (figure 9F).

Il est clair que les cartes mères ont été représentées aux figures 9A à 9F avec toutes la mème surface mais que les surfaces globales de ces cartes mères diffèrent selon leur appartenance à l'un ou l'autre des compartiments.

En d'autres termes, les surfaces globales de la carte mère et des ensembles de cartes mères 3A-3C de chaque plan ont des valeurs croissantes fonctions de leur position dans l'empilage de forme pyramidale.

Comme mentionné précédemment, la carte mère, ou l'ensemble de cartes mères, la plus proche de la face avant du tiroir a la surface la plus grande.

Concernant la réalisation technique du tiroir pour cartes électroniques, à titre d'exemple, les connecteurs de sortie sont soudés à la vague sur les cartes mères.

Ceci a comme avantage que le câblage de sortie se trouve être intégré dans le volume défini par la face avant du tiroir.

La fixation du tiroir à son coffre s'effectue au moyens de plusieurs vis.

## Revendications

1. Tiroir (1) avec cartes électroniques (2), ledit tiroir étant susceptible de s'introduire dans un support (11) de tiroir (1), lesdites cartes électroniques (2) étant connectées sur des cartes mères (3A-3C), lesdites cartes mères (3A-3C) étant disposées sur au moins deux plans, ledit tiroir étant à embrochement et débrochage automatiques et lesdites cartes mères (3A-3C) étant disposées parallèlement à la face avant (6) dudit tiroir (1).

2. Tiroir (1) et son support (11) selon la revendication 1, dans lesquels ledit support de tiroir est de forme générale intérieure semblable à l'enveloppe générale extérieure dudit tiroir (1).

3. Tiroir (1) et son support (11) selon l'une quelconque des revendications 1 et 2, dans lesquels des connecteurs de sortie (4A-4C) sont fixés audit support (11) de tiroir (1), des connecteurs (5A-5C) dudit tiroir (1) étant susceptibles d'être connectés automatiquement auxdits connecteurs de sortie (4A-4C).

4. Tiroir (1) selon l'une quelconque des revendications 1 à 3, dans lequel chaque plan comporte une ou plusieurs cartes mères (3A-3C), lesdites cartes mères et leurs cartes électroniques étant superposées les unes aux autres, de manière à former une superposition de compartiments (A-C) dont l'enveloppe générale extérieure est de forme générale pyramidale.

5. Tiroir (1) selon l'une quelconque des revendications 1 à 4, dans lequel la face avant du tiroir est disposée face à la carte mère, ou à l'ensemble des cartes mères d'un même plan, de surface la plus grande.

6. Tiroir (1) selon l'une quelconque des revendications 1 à 5, dans lequel des connecteurs de sortie (5A-5C) sont fixés aux extrémités desdites cartes mères (3A-3C).

7. Tiroir (1) selon l'une quelconque des revendications 1 à 6, dans lequel les compartiments du tiroir comportent des plaques de rigidification (8B-8D) des cartes mères (3A-3C) et/ou de plaques de protection (8A-8C) des cartes électroniques (2A-2C).

8. Tiroir (1) selon l'une quelconque des revendications 1 à 7, dans lequel au moins une carte mère d'un compartiment n a été supprimée de manière à augmenter le nombre de connecteurs sur la carte mère du compartiment suivant n+1.

9. Tiroir (1) selon l'une quelconque des revendications 1 à 7, dans lequel au moins une carte mère d'un compartiment n a été décalée, de manière à être alignée sur un des côtés du compartiment précédent n-1 ou du compartiment suivant n+1, afin que les connecteurs de ladite carte mère dudit compartiment n soient plus particulièrement disposés sur l'un des côté du tiroir.

10. Tiroir (1) selon l'une quelconque des revendications 1 à 7, dans lequel l'ensemble des compartiments A-C sont aligné sur un des côtés du tiroir, afin de disposer l'ensemble des connecteurs sur un seul côté du tiroir.

11. Tiroir (1) selon l'une quelconque des revendications 1 à 10, dans lequel au moins un compartiment comporte une carte mère unique.

12. Tiroir (1) selon l'une quelconque des revendications 1 à 10, dans lequel au moins un compartiment comporte deux demi-cartes mères.

13. Tiroir (1) selon l'une quelconque des revendications 1 à 10, dans lequel au moins un compartiment comporte quatre quarts de cartes mères.

14. Tiroir (1) selon l'une quelconque des revendications 1 à 10, dans lequel au moins un compartiment comporte une demi-carte mère et de deux quarts de cartes mères.

15. Tiroir (1) selon l'une quelconque des revendications 1 à 14, dans lequel les surfaces globales de la carte mère et des ensembles de cartes mères (3A-3C) de chaque plan ont des valeurs croissantes fonctions de leur position dans ledit empilage de forme pyramidale, la carte mère, ou l'ensemble de cartes mères, la plus proche de la face avant du tiroir ayant la surface la plus grande.

16. Tiroir (1) selon l'une quelconque des revendications 1 à 15, dans lequel les cartes mères (3A-3C) sont disposées sur des plans parallèles à la face avant (6) du tiroir (1) au moyens d'entretoises (7A-7C) solidaires desdites plaques de rigidification (8B-8D) des cartes mères (3A-3C) et/ou desdites plaques de protection (8A-8C) des cartes électroniques (2A-2C).

## Patentansprüche

1. Einschub (1) mit elektronischen Platinen(2), welcher geeignet ist, in einen Einschub-Träger (11) eingeführt zu werden, wobei die elektronischen Platinen an Hauptplatinen (3A-3C) angeschlossen sind, wobei die Hauptplatinen (3A-3C) in wenigstens zwei Ebenen angeordnet sind, der Einschub ein Einschub mit automatisch schließender und öffnender Steckverbindung ist und die Hauptplatinen parallel zur Vorderseite (6) des Einschubs (1) angeordnet sind.

2. Einschub (1) und dessen Träger (11) nach Anspruch 1, bei denen der Einschub-Träger (11) eine allgemeine innere Form ähnlich der allgemeinen äußeren Hülle des Einschubs (1) hat.

3. Einschub (1) und dessen Träger (11) nach einem beliebigen der Ansprüche 1 und 2, bei denen Ausgangsverbinder (4A-4C) an dem Einschub-Träger (11) befestigt sind und Verbinder (5A-5C) des Einschubs (1) geeignet sind, automatisch mit den Ausgangsverbindern (4A-4C) verbunden zu werden.

4. Einschub (1) nach einem beliebigen der Ansprüche 1 bis 3, bei dem jede Ebene eine oder mehrere Hauptplatinen (3A-3C) umfaßt, wobei die Hauptplatinen und ihre elektronischen Platinen einander so überlagert sind, daß sie eine Überlagerung von Kammern (A-C) bilden, deren allgemeine äußere Hülle allgemein pyramidenförmig ist.

5. Einschub (1) nach einem beliebigen der Ansprüche 1 bis 4, bei dem die Vorderseite des Einschubs derjenigen Hauptplatine oder Anordnung der Hauptplatinen einer gleichen Ebene zugewandt angeordnet ist, die die größte Oberfläche hat.

6. Einschub (1) nach einem beliebigen der Ansprüche 1 bis 5, bei dem die Ausgangsverbinder (5A-5C) an den Enden der Hauptplatinen (3A-3C) befestigt sind.

7. Einschub (1) nach einem beliebigen der Ansprüche 1 bis 6, bei dem die Kammern des Einschubs Versteifungsplatten (8B-8D) der Hauptplatinen (3A-3C) und/oder Schutzplatten (8A-8C) der elektronischen Platinen (2A-2C) umfassen

8. Einschub (1) nach einem beliebigen der Ansprüche 1 bis 7, bei dem wenigstens eine Hauptplatine einer Kammer n fortgelassen ist, um die Zahl von Verbindern an der Hauptplatine der folgenden Kammer n+1 zu erhöhen.

9. Einschub (1) nach einem beliebigen der Ansprüche 1 bis 7, bei dem wenigstens eine Hauptplatine einer Kammer n so versetzt ist, daß sie mit einer der Seiten der vorhergehenden Kammer n-1 oder der nachfolgenden Kammer n+1 fluchtet, so daß die Verbinder der Hauptplatine der Kammer n insbesondere an der einen Seite des Einschubs angeordnet sind.

10. Einschub (1) nach einem beliebigen der Ansprüche 1 bis 7, bei dem die Gesamtheit der Kammern A-C an einer Seite des Einschubs (1) fluchten, um sämtliche Verbinder an einer einzigen Seite des Einschubs anzuordnen.

11. Einschub (1) nach einem beliebigen der Ansprüche 1 bis 10, bei dem wenigstens eine Kammer eine einzige Hauptplatine umfaßt.

12. Einschub (1) nach einem beliebigen der Ansprüche 1 bis 10, bei dem wenigstens eine Kammer zwei Halb-Hauptplatinen umfaßt.

13. Einschub (1) nach einem beliebigen der Ansprüche 1 bis 10, bei dem wenigstens eine Kammer vier Viertel-Hauptplatinen umfaßt.

14. Einschub (1) nach einem beliebigen der Ansprüche 1 bis 10, bei dem wenigstens eine Kammer eine Halb-Hauptplatine und zwei Viertel-Hauptplatinen umfaßt.

15. Einschub (1) nach einem beliebigen der Ansprüche 1 bis 14, bei dem die globalen Oberflächen der Hauptplatine und der Gesamtheiten von Hauptplatinen (3A-3C) jeder Ebene in Abhängigkeit von ihrer Position in dem pyramidenförmigen Stapel zunehmende Werte haben, wobei die Hauptplatine oder die Gesamtheit von Hauptplatinen, die der Vorderseite des Einschubs am nächsten ist, die größte Oberfläche hat.

16. Einschub (1) nach einem beliebigen der Ansprüche 1 bis 15, bei dem die Hauptplatinen (3A-3C) auf zur Vorderseite (6) parallelen Ebenen des Einschubs (1) mit Hilfe von Verstrebungen (7A-7C) angeordnet sind, die mit den Versteifungsplatten (8B-8D) der Hauptplatinen (3A-3C) und/oder der Schutzplatten (8A-8C) der elektronischen Platinen (2A-2C) fest verbunden sind.

## Claims

1. Subrack (1) with electronic circuit boards (2) adapted to be inserted into a support (11) for the subrack (1), said electronic circuit boards (2) being connected to mother boards (3A-3C), said mother boards (3A-3C) being disposed in at least two planes, said subrack plugging in and unplugging automatically and said mother boards (3A-3C) being parallel to the front face (6) of said subrack (1).

2. Subrack (1) and its support (11) according to claim 1 wherein said subrack support has a general interior shape similar to the general exterior envelope of said subrack (1).

3. Subrack (1) and its support (11) according to claim 1 or claim 2 wherein output connectors (4A-4C) are fixed to said support (11) of the subrack (1), connectors (5A-5C) of said subrack (1) being adapted to connect automatically to said output connectors (4A-4C).

4. Subrack (1) according to any one of claims 1 to 3 wherein each plane contains one or more mother boards (3A-3C), said mother boards and their electronic circuit boards being superposed to form a stack of compartments (A-C) the general exterior envelope of which is generally pyramid shaped.

5. Subrack (1) according to any one of claims 1 to 4 wherein the front face of the subrack faces the mother board or the set of coplanar mother boards having the largest area.

6. Subrack (1) according to any one of claims 1 to 5 wherein male output connectors (5A-5C) are fixed to the ends of said mother boards (3A-3C).

7. Subrack (1) according to any one of claims 1 to 6 wherein the compartments of the subrack include stiffener plates (8B-8D) for the mother boards (3A-3C) and/or protective plates (8A-8C) for the electronic circuit boards (2A-2C).

8. Subrack (1) according to any one of claims 1 to 7 wherein at least one mother board of a compartment n is omitted to increase the number of connectors on the mother board of the next compartment n+1.

9. Subrack (1) according to any one of claims 1 to 7 wherein at least one mother board of a compartment n is offset to align it with one side of the previous compartment n-1 or the next compartment n+1 so that the connectors of said mother board of said compartment n can be disposed on one side of the subrack.

10. Subrack (1) according to any one of claims 1 to 7 wherein the compartments A-C are all aligned with one side of the subrack so that all of the connectors can be on one side of the subrack.

11. Subrack (1) according to any one of claims 1 to 10 wherein at least one compartment contains only one mother board.

12. Subrack (1) according to any one of claims 1 to 10 wherein at least one compartment contains two mother half-boards.

13. Subrack (1) according to any one of claims 1 to 10 wherein at least one compartment contains four mother quarter-boards.

14. Subrack (1) according to any one of claims 1 to 10 wherein at least one compartment contains one mother half-board and two mother quarter-boards.

15. Subrack (1) according to any one of claims 1 to 14 wherein the areas of the mother board and the sets of coplanar mother boards (3A-3C) have increasing values according to their position in said pyramid shaped stack, the mother board or the set of mother boards nearest the front face of the subrack having the greatest area.

16. Subrack (1) according to any one of claims 1 to 15 wherein the mother boards (3A-3C) are disposed in planes parallel to the front face (6) of the subrack (1) by means of spacers (7A-7C) fastened to said stiffener plates (8B-8D) of the mother boards (3A-3C) and/or said protective plates (8A-8C) of the daughter electronic circuit boards (2A-2C).
